Europäisches Patentamt

European Patent Office

Office européen des brevets

(11) Veröffentlichungsnummer: **0 015 488**
**A1**

## (12) EUROPÄISCHE PATENTANMELDUNG

(21) Anmeldenummer: 80100954.9

(22) Anmeldetag: 26.02.80

(51) Int. Cl.³: **H 01 L 25/14, H 01 L 23/40**

(30) Priorität: 08.03.79 DE 2909138

(43) Veröffentlichungstag der Anmeldung: 17.09.80
Patentblatt 80/19

(84) Benannte Vertragsstaaten: **DE FR GB SE**

(71) Anmelder: **SIEMENS AKTIENGESELLSCHAFT Berlin
und München, Postfach 22 02 61,
D-8000 München 22 (DE)**

(72) Erfinder: **Keller, Roman, Grossenbuch 126,
D-8524 Neunkirchen a.Br. (DE)**
Erfinder: **Kliesch, Günter, Waldstrasse 19,
D-8520 Erlangen (DE)**

(54) **Thyristorsäule.**

(57) Die Erfindung betrifft eine Thyristorsäule aus einem
Stapel von Thyristoren (5a) und Kühldosen (5b), zwei Endstücken (8, 9) und einer rahmenartigen Einspannvorrichtung (1) aus Kunststoff, die den Stapel und die Endstücke (8,
9) elektrisch isolierend umfaßt. Die Einspannvorrichtung (1)
besteht aus zwei gleichen Halbschalen (2) mit Nuten auf den
Außenflächen, in die nach dem Zusammensetzen Windungen von Glasfaserbündeln (23) gewickelt sind, die mit
Kunststoff vergossen sind. In jedes der Endstücke ist ein
Spannelement (10, 11) eingeschraubt, von denen wenigstens eines als elastischer Kraftspeicher ausgebildet ist. Da
die Einspannvorrichtung aus einem Kunststoff besteht und
im Bereich der Stapelenden gekrümmte Teile (4) enthält,
wird eine raumsparende Bauweise erzielt.

SIEMENS AKTIENGESELLSCHAFT     Unser Zeichen
Berlin und München             VPA **79** P 3 0 3 7   EUR

## Thyristorsäule

Die Erfindung betrifft eine Thyristorsäule, die aus einem Stapel von Thyristoren und Kühldosen, zwei Endstücken mit je einem Spannelement und einer rahmenartigen Einspannvorrichtung, die den Stapel und die Endstücke elektrisch isolierend umfaßt, besteht, wobei je ein Spannelement auf einem der beiden Enden des Stapels aufliegt und wenigstens eines der beiden Spannelemente elastisch ist.

Eine solche Thyristorsäule ist aus der DE-OS 19 14 790 und der Siemens-Zeitschrift 48 (1974), S. 791 bis 798 bekannt. In der dort beschriebenen Konstruktion wird ein Stapel, der aus alternierend angeordneten scheibenförmigen Halbleiterbauelementen und Kühldosen, wobei jedes Halbleiterbauelement zwischen zwei Kühldosen liegt, und zwei Isolierstücken an den beiden Enden des Stapels besteht, in eine rahmenartige Einspannvorrichtung aus Metall symmetrisch eingespannt. Die Einspannvorrichtung besteht aus Spannplatten und Zugstangen. In

Fi 2 Kgm / 27.02.1979

eine der Spannplatten ist ein elastisches Ausgleichselement eingeschraubt, das auf einem der Isolierstücke aufliegt. Die Abmessungen einer solchen Thyristorsäule werden durch die Luft- und Kriechstrecken bestimmt, die erforderlich sind, um die Einspannvorrichtung von dem unter höherer Spannung stehenden Stapel von Thyristoren und Kühldosen elektrisch zu isolieren. Die bekannte Thyristorsäule erfordert einen hohen Raumbedarf, da die Spannplatten über Isolierstücke mit den Enden des Stapels aus Thyristoren und Kühldosen verbunden sind und die Zugstangen in genügend großen Abständen von dem Stapel verlaufen müssen.

Der Erfindung liegt die Aufgabe zugrunde, eine Thyristorsäule der eingangs genannten Art so auszugestalten, daß sie bei ausreichender elektrischer Isolierung möglichst wenig Raum beansprucht.

Erfindungsgemäß wird diese Aufgabe dadurch gelöst, daß die rahmenartige Einspannvorrichtung aus zwei gleichen Halbschalen aus einem Isolierstoff besteht, deren Außenflächen stetig verlaufen und deren Stirnflächen bei stetigem Übergang der Außenflächen aneinanderstoßen, daß jede der beiden Halbschalen mindestens einen geraden Teil und mindestens einen gekrümmten Teil aufweist, daß die beiden Endstücke etwa formschlüssig in je einem der beiden gekrümmten Teile der Einspannvorrichtung liegen, daß auf der Außenfläche jeder der beiden Halbschalen stellenweise wenigstens eine Vertiefung parallel zu den Seitenflächen der Halbschale verläuft und daß in die Vertiefung mehr als eine beide Halbschalen umfassende Windung eines Bündels von Fasern gewickelt ist, das in eine Vergußmasse eingelagert ist.

Wegen der Ausführung der Halbschalen aus einem Isolierstoff kann die Einspannvorrichtung in geringem Abstand von dem unter höherer Spannung stehenden Stapel aus Thyristoren und Kühldosen verlaufen, wodurch eine raumsparende Bauweise erreicht wird. Der Aufbau der Einspannvorrichtung aus zwei gleichen Halbschalen ist für die Serienproduktion vorteilhaft, da als Ausgangsmaterial, abgesehen von den Faserbündeln und der Vergußmasse, nur eine Art der Halbschale als Bauteil erforderlich ist. Die auf den Außenflächen der beiden zusammengesetzten Halbschalen umlaufenden Windungen von Faserbündeln verbinden die beiden Halbschalen der Einspannvorrichtung. Die Außenflächen der beiden Halbschalen verlaufen stetig, damit die aufgebrachten Windungen von Faserbündeln knickfrei umlaufen. Im Bereich der Stirnflächen der aneinanderstoßenden Halbschalen gehen die Außenflächen stetig ineinander über, damit die Faserbündel an den Übergangsstellen zwischen den beiden Halbschalen ohne Knicke verlaufen. Dadurch werden Brüche der umlaufenden Glas- oder Kohlefasern vermieden. An jeder Stelle auf der Außenfläche der Einspannvorrichtung liegen die Faserbündel tangential an der Einspannvorrichtung an, so daß keine Knickmomente in der Einspannvorrichtung auftreten. Die in die Vertiefungen auf der Außenfläche der Einspannvorrichtung gewickelten und vergossenen Windungen von Glasfaserbündeln oder Kohlefaserbündeln ergeben in diesen Bereichen einen faserverstärkten Kunststoff, der die Festigkeit der Einspannvorrichtung erhöht. Durch die gekrümmte Ausbildung von Teilen der Einspannvorrichtung und die etwa formschlüssig in ihnen liegenden Endstücke werden die beim Spannen der Thyristorsäule auftretenden Kräfte auf die geraden Teile der Einspannvorrichtung übertragen.

Vorteilhaft ist es, wegen der leichten und damit köstengünstigen Verarbeitung die Halbschalen aus einem Kunststoff herzustellen.

Vorzugsweise sind Bündel aus Glasfasern oder aus Kohlefasern um die beiden Halbschalen gewickelt, da sie zusammen mit dem vergossenen Kunststoff einen verstärkten
Kunststoff ergeben und damit zur Erhöhung der Festigkeit beitragen. Der elektrischen Leitfähigkeit von
Kohlefasern kann dadurch entgegengewirkt werden, daß
die Halbschalen dicker ausgebildet sind.

Vorzugsweise sind die beiden Halbschalen so ausgebildet,
daß sie einen geraden Teil und zwei gekrümmte Teile an
ihren Enden aufweisen. In der montierten Einspannvorrichtung befinden sich die Verbindungsstellen zwischen
den beiden Halbschalen in den Mitten der beiden gekrümmten Teile der Einspannvorrichtung. Die Verbindungsstellen liegen damit zwischen den Endstücken und den umlaufenden Bahnen aus verstärktem Kunststoff und nach
dem Spannen der Thyristorsäule formschlüssig auf den
darunterliegenden Endstücken.

Vorteilhaft ist es, die gekrümmten Teile der beiden
Halbschalen kreisbogenförmig auszubilden, weil dadurch
eine gute Formschlüssigkeit der an die gekrümmten Teile
angepaßten Endstücke erreicht wird.

Vorteilhaft ist es, für den Zusammenbau der Einspannvorrichtung die Vertiefungen auf den Außenflächen der
beiden gekrümmten Teile der Einspannvorrichtung anzubringen.

Vorzugsweise werden zwei parallel verlaufende Vertiefungen auf den Außenflächen der Halbschalen angebracht, um eine gleichmäßige Belastung der Einspannvorrichtung zu erreichen.

Es kann auf der Innenseite der Einspannvorrichtung eine Führung umlaufen, die beispielsweise für Zuleitungen oder die Zentrierung von Bauteilen verwendet wird. Vorzugsweise verläuft diese Führung in der Mitte symmetrisch zu den Seitenflächen der Einspannvorrichtung. Vorteilhaft ist es, wenn die Außenfläche über der Führung von Faserbündeln frei ist, weil in diesem Bereich Bohrungen durch die Einspannvorrichtung ausgeführt werden können, ohne daß dadurch Windungen von Faserbündeln unterbrochen werden. Derartige Durchbrüche können für Stromzuführungen, Kühlmittelzuführungen oder andere Zwecke benutzt werden.

Vorzugsweise befindet sich in der Mitte der beiden gekrümmten Teile der Einspannvorrichtung je ein Durchbruch, der den Zugriff zu den in die Endstücke eingeschraubten Spannelementen ermöglicht. Dadurch können Teile des Stapels aus Thyristoren und Kühldosen nachträglich ausgewechselt werden.

Der Querschnitt der Vertiefungen in der Einspannvorrichtung kann unterschiedlich ausgebildet sein, z. B. rechteckförmig, U-förmig oder trapezförmig. Entsprechend der Querschnittsform der Vertiefung kann die Abfolge und damit die Raumerfüllung mit Windungen von Glas- oder Kohlefaserbündeln variieren, was aus wicklungs- und vergußtechnischen Gründen von Vorteil sein kann. Eine Vertiefung mit gezackter Sohle kann der ersten Lage der Windungen von Glasfaserbündeln einen rutschfesten Halt bieten.

Vorzugsweise liegen die Spannelemente über Spitzenlagerungen auf den Endflächen des Stapels aus Thyristoren und Kühldosen auf. Durch diese Art der Kraftübertragung können Schwankungen in der Planparallelität der in dem Stapel zusammengepreßten Thyristoren und Kühldosen ebenso wie thermische Spannungen leicht auf das elastische Ausgleichselement übertragen werden, da sich die Spitzenlagerungen gelenkartig gegen die Endflächen des Stapels aus Thyristoren und Kühldosen bewegen können.

Ein Ausführungsbeispiel der Erfindung wird anhand der Figuren dargestellt und beschrieben. Die in verschiedenen Figuren auftretenden gleichen Elemente sind mit gleichen Bezugszeichen bezeichnet.

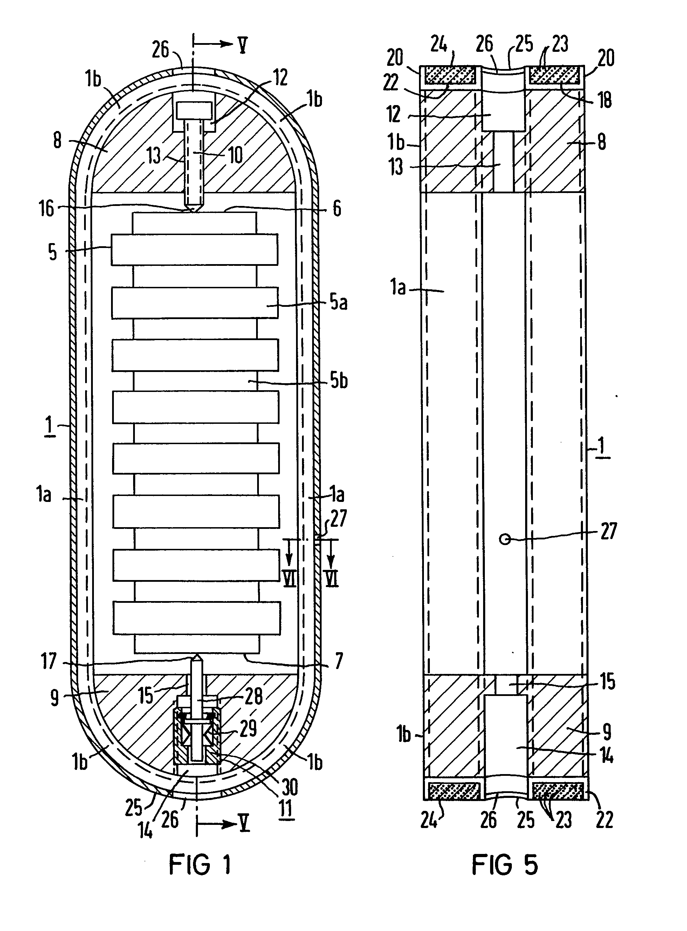

In Figur 1 ist ein Schnitt durch eine Thyristorsäule dargestellt. Die rahmenartige Einspannvorrichtung 1 umfaßt den Stapel 5, der aus den Thyristoren 5a und den Kühldosen 5b besteht, und die Endstücke 8 und 9, in die die Spannelemente 10 und 11 eingeschraubt sind. Die Einspannvorrichtung 1 besteht aus zwei geraden Teilen 1a und zwei kreisbogenförmig gekrümmten Teilen 1b von der Bogenlänge eines Halbkreises. Die Thyristoren 5a und die Kühldosen 5b sind alternierend angeordnet, wobei jeder Thyristor 5a zwischen zwei Kühldosen 5b liegt. Anstatt flüssigkeitsgekühlter Kühldosen können auch luftgekühlte Kühlkörper verwendet werden. Die Kühldosen 5b dienen auch zur Stromführung in dem Stapel 5. Die Endstücke 8 und 9 besitzen einen kreisabschnittförmigen Querschnitt und liegen mit ihrer kreisbogenförmigen Seite formschlüssig in den kreisbogenförmig gekrümmten Teilen 1b der Einspannvorrichtung 1. Die Endstücke 8 und 9 können als Stromzuführungen verwendet werden. Im Endstück 8 sind die Bohrung 12 und der Durchbruch 13 für die Aufnahme des Spannelementes 10 und im Endstück 9 sind die Bohrung 14 und der Durchbruch 15 für die Aufnahme des Spannelementes 11 angebracht. Die beiden Spannelemente 10 und 11, von denen wenigstens eines als elastischer Kraftspeicher ausgebildet ist, liegen auf den Endflächen 6 und 7 des Stapels 5 auf. Als Spannelement 10 dient eine Schraube. Das in das Endstück 9 eingeschraubte Spannelement 11 ist ein elastisches Ausgleichselement. Das Spannelement 11 besteht aus einem Puffer 28, einigen Tellerfedern 29 und einem Lagerteil 30. Der Puffer 28 wird von den Tellerfedern 29 gegen die Endfläche 7 des Stapels 5 gedrückt. Die Tellerfedern 29 liegen in einem konzentrischen Zwischenraum zwischen dem Puffer 28 und dem Lagerteil 30. Das Lagerteil 30 ist in das Endstück 9 eingeschraubt. Die rahmenartige Einspannvorrichtung 1 stellt zusammen mit dem Endstück 9 und dem Lagerteil 30 das Widerlager für die Tellerfedern 29 dar. Ein Spannelement dieser Art wurde in der DE-OS 19 14 790 ausführlich beschrieben. In den Mitten der kreisbogenförmig gekrümmten Teile 1b der Einspannvorrichtung 1 befindet sich je ein Durchbruch 26. Über die beiden Durchbrüche 26 sind die Spannelemente 10 und 11 zugänglich. Durch Betätigen eines der oder beider Spannelemente 10 und 11 wird die erforderliche Anpreßkraft auf die Endflächen 6 und 7 des Stapels 5 übertragen. Die Spannelemente 10 und 11 liegen über die Spitzenlagerungen 16 und 17 auf den Endflächen 6 und 7 des Stapels 5 auf. Die Spitzenlagerungen 16 und 17 können sich gelenkartig gegen die Endflächen 6 und 7 des Stapels 5 bewegen. Bei der Grobeinstellung der Anpreßkraft können sich die Endstücke 8 und 9 in den kreisbogenförmig gekrümmten Teilen 1b der Einspannvorrichtung 1 durch Drehen um kleine Winkel ausrichten. Abweichungen von der Planparallelität der Auflageflächen der in Stapel 5 enthaltenen Thyristoren und Kühldosen werden ebenso leicht wie thermische

0015488

Spannungen, die beim Einsatz der Thyristorsäule bei unterschiedlichen Temperaturen in dem Stapel 5 auftreten können, über die Spitzenlagerung 17 auf das Spannelement 11 übertragen und von diesem ausgeglichen. Die Einspannvorrichtung 1 besteht aus zwei gleichen Halbschalen aus Kunststoff, die von umlaufenden Bahnen aus verstärktem Kunststoff zusammengehalten werden. Das Umwickeln mit Faserbündeln, deren Lage auf der Einspannvorrichtung 1 und das Vergießen werden im Zusammenhang mit den Figuren 5 bis 9 beschrieben. Es können Glasfaserbündel oder Kohlfaserbündel verwendet werden. Im folgenden werden Glasfaserbündel für die Windungen um die Einspannvorrichtung den weiteren Betrachtungen zugrunde gelegt. Durch die kreisbogenförmig gekrümmten Teile 1b der Einspannvorrichtung 1 und die mit ihren kreisbogenförmigen Seiten in ihnen liegenden Endstücke 8 und 9 werden die beim Spannen der Thyristorsäule auftretenden Kräfte auf die geraden Teile 1a der Einspannvorrichtung 1 übertragen. An jeder Stelle auf der Außenfläche liegen die Glasfaserbündel tangential an der Einspannvorrichtung 1 an, so daß keine Knickmomente in der Einspannvorrichtung 1 auftreten. In dem Teil 1a ist ein Durchbruch 27 angebracht, der z. B. für die Halterung von Zuleitungen oder die Zentrierung von Bauteilen verwendet werden kann.

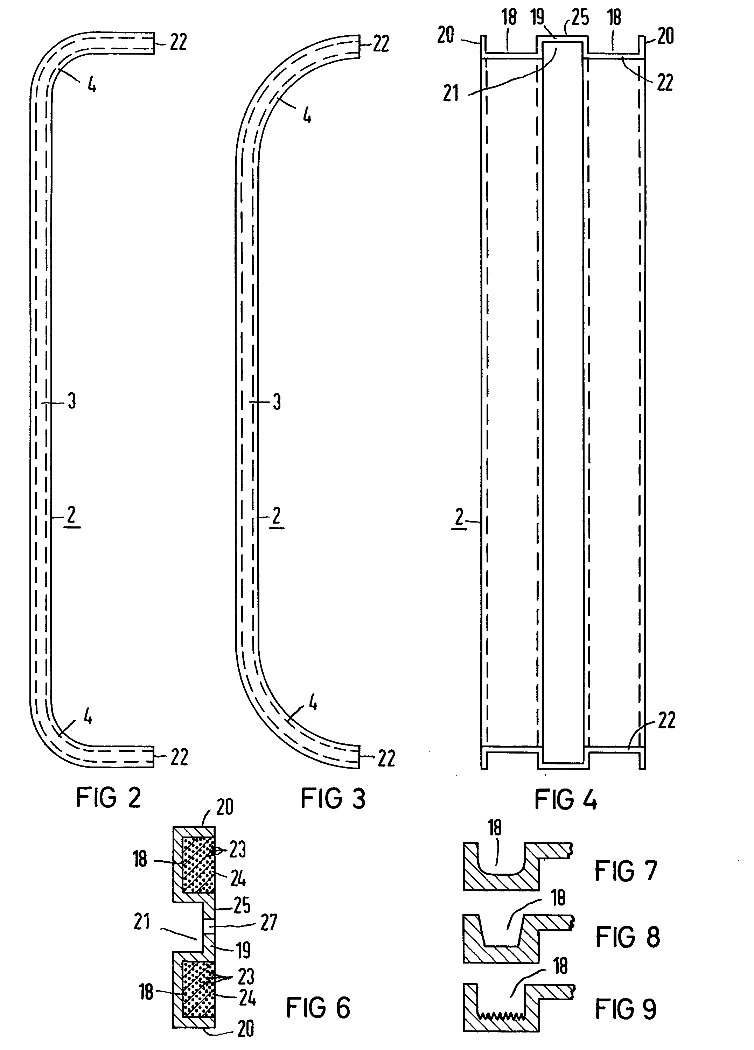

Die Einspannvorrichtung 1 besteht aus zwei gleichen Halbschalen 2 aus einem Kunststoff, z. B. Polyesterharz. In den Figuren 2 und 3 sind Seitenansichten von unterschiedlich geformten Halbschalen dargestellt. Die in Figur 2 dargestellte Halbschale 2 besteht aus einem geraden Teil 3 und zwei sich anschließenden Teilen 4, die aus je einem gekrümmten und einem geraden Teil bestehen und von den Stirnflächen 22 begrenzt werden. Die Halbschale 2 in Figur 3 besteht aus einem geraden Teil 3 und zwei kreisbogenförmig gekrümmten Teilen 4 von der Bogenlänge eines Viertelkreises. Die kreisbogenförmig gekrümmten Teile 4 werden von je einer Stirnfläche 22 begrenzt. Die in Figur 3 dargestellte Form der Halbschale wird den folgenden Betrachtungen zugrunde gelegt. Nach Zusammensetzen der beiden Halbschalen 2 derart, daß ihre Stirnflächen 22 aufeinanderliegen, ergibt sich die im Zusammenhang mit Figur 1 beschriebene rahmenartige Einspannvorrichtung 1. Neben den beschriebenen Formen der Halbschale 2 sind andere Formen möglich. Die Halbschale kann auch aus zwei geraden Teilen und einem kreisbogenförmig gekrümmten Teil von der Bogenlänge eines Halbkreises bestehen. Nach Zusammensetzen zweier solcher Halbschalen ergibt sich eine rahmenartige Einspannvorrichtung von der gleichen Form wie Teil 1 in Figur 1. Die Verbindungsstellen zwischen den beiden Halbschalen befinden sich dann in den geraden Teilen der Einspannvorrichtung und nicht in ihren kreisbogenförmig gekrümmten Teilen. Der Vorteil der Erfindung kann auch durch andere als die hier beschriebenen Formen der Halbschale zum Ausdruck kommen, beispielsweise durch die elliptische Krümmung des Teiles 4. Die Länge des geraden Teiles 3 der Halbschale 2 muß an die Höhe des Stapels 5 aus Thyristoren und Kühldosen (Fig. 1) angepaßt sein.

Die Frontansicht auf eine Halbschale 2 der Einspannvorrichtung 1 zeigt Figur 4. Auf der Außenfläche der Halbschale 2 laufen parallel zu den Seitenflächen 20 zwei Vertiefungen 18 um. Die Vertiefungen 18 sind als Nut mit rechteckförmigem Querschnitt ausgebildet und symmetrisch zwischen einem Mittelteil 19, der im mittleren Bereich auf der Außenfläche der Halbschale 2 umläuft, und den beiden Seitenflächen 20 angeordnet. Der Mittelteil 19 wird nach außen von der Fläche 25 begrenzt. Die symmetrische Anordnung der beiden Vertiefungen 18 ist für die gleichmäßige Belastung der Einspannvorrichtung 1 erforderlich. Dieser Sachverhalt
wird im Zusammenhang mit Figur 5 beschrieben. Auf der
Innenfläche der Halbschale 2 läuft eine Führung 21
parallel zu den Seitenflächen 20 der Halbschale 2 als
Innennut um. Die Führung 21 befindet sich im mittleren
Bereich zwischen den beiden Seitenflächen der Halbschale 2 unter dem Mittelteil 19. Die Führung 21 ist
für spezielle Zwecke vorgesehen. Sie dient z. B. zur
Führung oder Aufnahme von Zuleitungen oder zur Zentrierung von Bauelementen. Die beiden Stirnflächen 22
begrenzen die Halbschale 2.

Die beiden Halbschalen 2 werden so zu der in Figur 1
beschriebenen rahmenartigen Einspannvorrichtung 1 zusammengesetzt, daß die Stirnflächen 22 der beiden Halbschalen 2 aufeinanderliegen. In Figur 5 ist ein Schnitt
durch die Einspannvorrichtung 1 mit den Endstücken 8
und 9 ohne die Spannelemente 10 und 11 und ohne den
Stapel 5 aus Thyristoren und Kühldosen senkrecht zur
Schnittrichtung von Figur 1 dargestellt. In die Vertiefungen 18, die auf der gesamten Außenfläche der beiden
zusammengesetzten Halbschalen 2 umlaufen und an den
Verbindungsstellen im Bereich der Stirnflächen 22 der
beiden Halbschalen 2 fluchten, werden einige Windungen
von Glasfaserbündeln 23 gewickelt. Eine Windung ist dabei ein vollständiger, in sich geschlossener Umlauf
eines Glasfaserbündels 23 um die Einspannvorrichtung 1.
Die Windungen aus Glasfaserbündeln 23 werden mit einer
Vergußmasse (24), vorzugsweise einem flüssigen Kunststoff,
z. B. Polyesterharz, vergossen, wodurch die Glasfaserbündel in die Vertiefungen 18 fest eingebettet werden.
Durch den entstandenen glasfaserverstärkten Kunststoff
ergibt sich im Bereich der aufeinanderliegenden Stirnflächen 22 eine feste Verbindung zwischen den beiden Halbschalen 2. In dem Endstück 8 sind die Bohrung 12 und der Durchbruch 13 für die Aufnahme des Spannelementes 10 und in dem Endstück 9 sind die Bohrung 14 und der Durchbruch 15 für die Aufnahme des Spannelementes 11 angebracht. Die beiden Durchbrüche 26 durch die Einspannvorrichtung 1 liegen über den Bohrungen 12 und 14 in den Endstücken 8 und 9. Durch die Bohrungen 26 sind die Spannelemente 10 und 11 zugänglich. Die über dem Mittelteil 19 liegende Fläche 25, die in den Figuren 4 und 6 deutlicher hervortritt, ist an den Stirnflächen 22 als Linie zu erkennen. Im geraden Teil 1a der Einspannvorrichtung 1 ist auf der Fläche 25 ein Durchbruch 27 angebracht. Solche Durchbrüche 27 können an beliebigen Stellen auf der Fläche 25 ausgeführt und z. B. für die Halterung von Zuleitungen oder die Zentrierung von Bauteilen verwendet werden. Für die Festigkeit in der Einspannvorrichtung 1, vor allem in den stark beanspruchten Teilen 1b, wäre es am günstigsten, Windungen von Glasfaserbündeln 23 möglichst gleichmäßig über die gesamte Breite der Außenfläche der Einspannvorrichtung 1 zu wickeln. Das ist nicht möglich, da für die Durchbrüche 27 die von Glasfaserbündeln freie Fläche 25 erforderlich ist. Wären Glasfaserbündel auf der Fläche 25 vorhanden, so würden sie durch die Bohrungen 27 unterbrochen und damit keinen Beitrag zur Festigkeit der Einspannvorrichtung liefern. Um trotzdem eine möglichst gleichmäßige Belastung der Einspannvorrichtung 1 vor allem in den Teilen 1b zu erreichen, sind die beiden Vertiefungen 18 und damit die Windungen von Glasfaserbündeln 23 symmetrisch zum Mittelteil 19 angeordnet.

Figur 6 zeigt einen Schnitt durch einen Teil der Einspannvorrichtung 1, der die vergossenen Glasfaserbündel herausstellt. Die mit Kunststoff 24 vergossenen Glasfaserbündel 23 befinden sich in den Vertiefungen 18.
Unter dem Mittelteil 19 befindet sich die als Innennut
ausgebildete Führung 21. Die Fläche 25 auf dem Mittelteil 19 ist frei von Glasfasern und Vergußmasse. Das
erweist sich als günstig, weil beim Ausführen von Bohrungen 27 keine Windungen von Glasfaserbündeln unterbrochen
werden. Außerdem können die Bohrungen 27 leichter ausgeführt werden.

In den Figuren 7 bis 9 sind weitere Ausführungsformen
der Vertiefung 18 dargestellt. In Figur 7 weist die Vertiefung 18 einen U-förmigen Querschnitt und in Figur 8
einen trapezförmigen Querschnitt auf. Bei diesen Querschnittsformen unterscheiden sich die Packungsdichte
und damit die Raumerfüllung mit Windungen von Glasfaserbündeln von Vertiefungen mit rechteckiger Querschnittsform (Fig. 4 bis 6). Vertiefungen mit solchen Querschnittsformen können den Vorteil haben, daß die Vergußmasse leichter zwischen die Windungen von Glasfaserbündeln einfließen und die Zwischenräume zwischen den
Glasfaserbündeln besser ausfüllen kann. Dadurch kann
eine höhere Festigkeit der umlaufenden Bahnen aus glasfaserverstärktem Kunststoff erreicht werden. In Figur 9
ist eine Vertiefung 18 mit gezackter Sohle dargestellt.
Eine Vertiefung mit gezackter Sohle kann der ersten
Lage der Windungen von Glasfaserbündeln eine rutschfeste
Unterlage bieten.

19 Patentansprüche
9 Figuren

Patentansprüche

1. Thyristorsäule, die aus einem Stapel von Thyristoren und Kühldosen, zwei Endstücken mit je einem Spannelement und einer rahmenartigen Einspannvorrichtung, die den Stapel und die Endstücke elektrisch isolierend umfaßt, besteht, wobei je ein Spannelement auf einem der beiden Enden des Stapels aufliegt und wenigstens eines der beiden Spannelemente elastisch ist, d a d u r c h g e k e n n z e i c h n e t, daß die rahmenartige Einspannvorrichtung (1) aus zwei gleichen Halbschalen (2) aus einem Isolierstoff besteht, deren Außenflächen stetig verlaufen und deren Stirnflächen (22) bei stetigem Übergang der Außenflächen aneinanderstoßen,

daß jede der beiden Halbschalen (2) mindestens einen geraden Teil (3) und mindestens einen gekrümmten Teil (4) aufweist,

daß die beiden Endstücke (8, 9) etwa formschlüssig in je einem der beiden gekrümmten Teile (1b) der Einspannvorrichtung (1) liegen,

daß auf der Außenfläche jeder der beiden Halbschalen (2) stellenweise wenigstens eine Vertiefung (18) parallel zu den Seitenflächen (20) der Halbschale (2) verläuft,

daß in die Vertiefung (18) mehr als eine beide Halbschalen umfassende Windung eines Bündels von Fasern (23) gewickelt ist, das in eine Vergußmasse eingelagert ist.

2. Thyristorsäule nach Anspruch 1, d a d u r c h g e k e n n z e i c h n e t, daß der Isolierstoff ein Kunststoff ist.

Fi 2 Kgm / 27.02.1979

3. Thyristorsäule nach Anspruch 2, d a d u r c h  g e - k e n n z e i c h n e t, daß die Fasern (23) Glasfasern sind.

4. Thyristorsäule nach Anspruch 2, d a d u r c h  g e - k e n n z e i c h n e t, daß die Fasern (23) Kohlefasern sind.

5. Thyristorsäule nach einem der Ansprüche 1 bis 4, d a - d u r c h  g e k e n n z e i c h n e t, daß die Verguß- masse ein Kunststoff ist.

6. Thyristorsäule nach einem der Ansprüche 1 bis 5, d a - d u r c h  g e k e n n z e i c h n e t, daß die Halb- schale (2) zwei gekrümmte Teile (4) aufweist.

7. Thyristorsäule nach einem der Ansprüche 1 bis 6, d a - d u r c h  g e k e n n z e i c h n e t, daß die ge- krümmten Teile (4) der beiden Halbschalen (2) kreisbogenförmig mit Bogenlängen von je einem Viertelkreis ausgebildet sind.

8. Thyristorsäule nach einem der Ansprüche 1 bis 7, d a - d u r c h  g e k e n n z e i c h n e t, daß die Ein- spannvorrichtung (1) die Vertiefung (18) in ihren gekrümmten Teilen (1b) aufweist.

9. Thyristorsäule nach einem der Ansprüche 1 bis 8, d a - d u r c h  g e k e n n z e i c h n e t, daß jede der beiden Halbschalen (2) zwei parallel verlaufende Vertiefungen (18) aufweist.

10. Thyristorsäule nach einem der Ansprüche 1 bis 9, d a - d u r c h  g e k e n n z e i c h n e t, daß sich auf der Innenfläche der Einspannvorrichtung (1) stellen-

0015488

weise mindestens eine Führung (21) parallel zu den
Seitenflächen (20) der Einspannvorrichtung (1) befindet.

11. Thyristorsäule nach Anspruch 10, d a d u r c h
g e k e n n z e i c h n e t, daß sich die Führung (21)
in der Mitte zwischen den beiden Seitenflächen (20) der
Einspannvorrichtung (1) befindet.

12. Thyristorsäule nach Anspruch 10, d a d u r c h
g e k e n n z e i c h n e t, daß die Außenfläche (25)
über der Führung (21) frei von Fasern ist.

13. Thyristorsäule nach einem der Ansprüche 1 bis 12,
d a d u r c h  g e k e n n z e i c h n e t, daß die
Einspannvorrichtung (1) in den Mitten ihrer gekrümmten
Teile (1b) und in der Mitte zwischen ihren beiden Seitenflächen (20) je einen Durchbruch (26) aufweist, über
den das Spannelement (10, 11) zugänglich ist.

14. Thyristorsäule nach einem der Ansprüche 1 bis 13,
d a d u r c h  g e k e n n z e i c h n e t, daß die
Vertiefung (18) in der Einspannvorrichtung (1) einen
rechteckförmigen Querschnitt aufweist.

15. Thyristorsäule nach einem der Ansprüche 1 bis 13,
d a d u r c h  g e k e n n z e i c h n e t, daß die
Vertiefung (18) in der Einspannvorrichtung (1) einen
U-förmigen Querschnitt aufweist.

16. Thyristorsäule nach einem der Ansprüche 1 bis 13,
d a d u r c h  g e k e n n z e i c h n e t, daß die
Vertiefung (18) in der Einspannvorrichtung (1) einen
trapezförmigen Querschnitt aufweist.

17. Thyristorsäule nach einem der Ansprüche 1 bis 16,

d a d u r c h   g e k e n n z e i c h n e t, daß die
Sohle der Vertiefung (18) in der Einspannvorrichtung (1)
einen gezackten Querschnitt aufweist.

18. Thyristorsäule nach einem der Ansprüche 1 bis 17,
d a d u r c h   g e k e n n z e i c h n e t, daß die
Einspannvorrichtung (1) an festgelegten Stellen der
Außenfläche (25) über der Führung (21) Durchbrüche (27)
aufweist.

19. Thyristorsäule nach einem der Ansprüche 1 bis 18,
d a d u r c h   g e k e n n z e i c h n e t, daß die
Spannelemente (10, 11) über zwei Spitzenlagerungen (16,
17) auf den Endflächen (6, 7) des Stapels (5) aus
Thyristoren und Kühldosen aufliegen.

FIG 1

FIG 5

FIG 2

FIG 3

FIG 4

FIG 6

FIG 7

FIG 8

FIG 9

Europäisches Patentamt

**EUROPÄISCHER RECHERCHENBERICHT**

0015488

Nummer der Anmeldung

EP 80 10 0954

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | DE - A - 1 514 161 (LICENTIA) <br> * Figur 1; Anspruch 1 * | 1 |
| A | US - A - 3 447 118 (WESTINGHOUSE) <br> * Figur; Anspruch 1 * | 1,19 |
| | GB - A - 1 021 149 (STANDARD TELE-PHONES AND CABLES LTD.) <br> * Figuren 1,3,4; Ansprüche 1,10 * | 1,2 |
| | DE - B - 1 064 650 (SIEMENS) <br> * Figuren 1,2; Anspruch 1 * | 1 |

**KLASSIFIKATION DER ANMELDUNG (Int.Cl. ³)**

H 01 L 25/14
            23/40

**RECHERCHIERTE SACHGEBIETE (Int. Cl. ³)**

H 01 L 25/14
            23/40

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patent-familie, übereinstimmendes Dokument

Der vorliegende Recherchenbericht wurde für alle Patentansprüche erstellt.

| Recherchenort: | Abschlußdatum der Recherche | Prüfer |
|---|---|---|
| Den Haag | 28-05-1980 | DE RAEVE |

EPA form 1503.1   06.78